(19) Europäisches Patentamt
European Patent Office
Office européen des brevets

(11) **EP 3 460 684 B1**

(12) **EUROPEAN PATENT SPECIFICATION**

(45) Date of publication and mention
of the grant of the patent:
**11.11.2020 Bulletin 2020/46**

(51) Int Cl.:
***G06F 30/00*** (2020.01)

(21) Application number: **18192754.2**

(22) Date of filing: **05.09.2018**

(54) **METHOD OF BLANK DESIGN FOR A SPIN FORMING PROCESS**

VERFAHREN ZUR ROHLINGSGESTALTUNG FÜR EINEN SPINFORMPROZESS

PROCÉDÉ DE CONCEPTION D'ÉBAUCHE POUR UN PROCESSUS DE FORMATION PAR ROTATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.09.2017 GB 201714184**

(43) Date of publication of application:
**27.03.2019 Bulletin 2019/13**

(73) Proprietor: **Nissan Motor Manufacturing (UK) Ltd Bedford**
**Bedfordshire MK43 0DB (GB)**

(72) Inventors:
• **LOUKAIDES, Evripides**
**Bath, BA2 7AY (GB)**
• **RUSSO, Iacopo Maria**
**Cambridge, CB2 1PZ (GB)**

(56) References cited:
• **LOUKAIDES EVRIPIDES G ET AL: "Toolpath generation for asymmetric mandrel-free spinning", PROCEDIA ENGINEERING, vol. 207, 17 September 2017 (2017-09-17), pages 1707-1712, XP085261512, ISSN: 1877-7058, DOI: 10.1016/J.PROENG.2017.10.926**

• **FAZLI A ET AL: "A comparison of numerical iteration based algorithms in blank optimization", FINITE ELEMENTS IN ANALYSIS AND DESIGN, ELSEVIER, AMSTERDAM, NL, vol. 50, 26 September 2011 (2011-09-26), pages 207-216, XP028394834, ISSN: 0168-874X, DOI: 10.1016/J.FINEL.2011.09.011 [retrieved on 2011-10-03]**

• **LOUKAIDES E G ET AL: "Automatic design of sheet metal forming processes by "un-forming"", INTERNATIONAL JOURNAL OF MECHANICAL SCIENCES, PERGAMON PRESS, OXFORD, GB, vol. 113, 23 April 2016 (2016-04-23), pages 61-70, XP029568715, ISSN: 0020-7403, DOI: 10.1016/J.IJMECSCI.2016.04.008**

• **Naval Kishor ET AL: "Optimization of initial blank shape to minimize earing in deep drawing using finite element method", Journal of Materials Processing Tech, 1 January 2002 (2002-01-01), pages 20-30, XP055553497, DOI: 10.1016/S0924-0136(02)00790-2 Retrieved from the Internet: URL:https://ac.els-cdn.com/S092401360200790 02/1-s2.0-S0924013602007902-main.pdf?_tid= 6b079e7c-4baa-4e17-9540-be31e1262d36&acdn a t=1549546204_dafb20cf8e23df4f077eea47c9309 60b [retrieved on 2019-02-07]**

## Description

TECHNICAL FIELD

The present disclosure relates to a method of designing a blank workpiece for a spin forming process. Aspects of the invention relate to a method of designing a blank workpiece, to a method of producing a blank workpiece, for use in a spin forming process, and to a method of producing an article in a spin forming process from a blank workpiece.

BACKGROUND

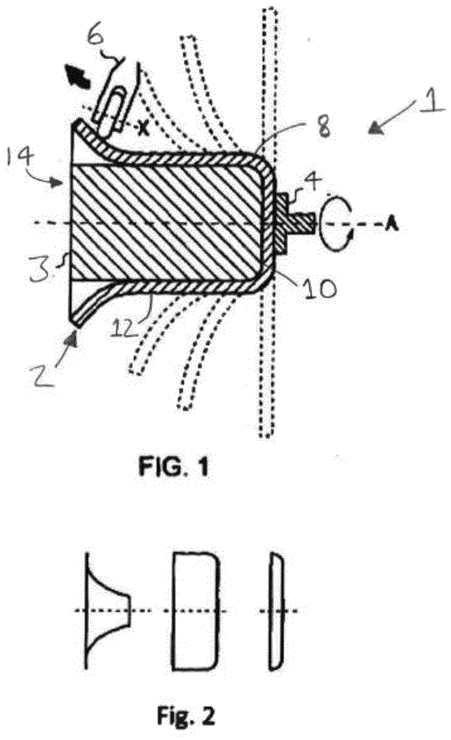

Metal spinning is a metal forming process which has traditionally been used to produce hollow, axially symmetric (axisymmetric) items or articles from a metal blank. Figure 1 illustrates a traditional spin forming apparatus 1. A workpiece 2, typically in the form of a metal blank, is secured to a mandrel 3 on a spinning lathe 4 and the workpiece 2 is gradually deformed into a desired shape by applying pressure, from a forming tool 6, onto an outer surface 8 of the workpiece 2, as it rotates. The workpiece 2 presses against the mandrel 3 as it deforms, such that one end of the mandrel 3 defines a base shape 10 of the article and longitudinal surfaces of the mandrel 3 define a length 12 of the article with an opening 14 at a free end. This process may, for example, be used to produce any of the axisymmetric articles shown in Figure 2 and may be completed in a single pass of the forming tool 6 over the workpiece 2 (shear spinning) or by multiple passes over the workpiece 2 (conventional spinning).

Metal spinning is advantageous in that there is minimal springback of the finished article and the initial tooling costs are relatively low. However, conventional spinning methods are unable to produce re-entrant shapes, due to the need to remove the finished article from the underlying mandrel 3. As a result, the finished articles are generally axisymmetric with little complexity.

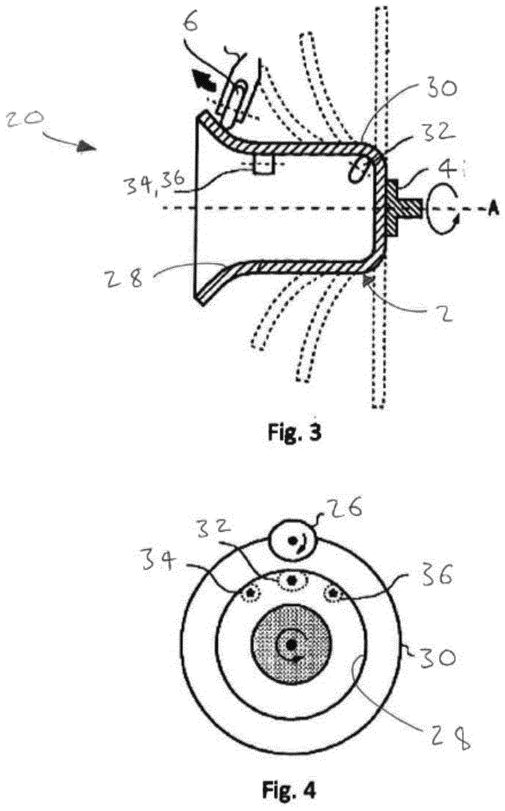

More recently, metal spinning methods have been developed which are mandrel-free. WO 2012/042221 A1 describes a mandrel-free spinning apparatus 20 for spin forming both axisymmetric and non-axisymmetric articles. The mandrel-free spinning apparatus 20, illustrated in Figures 3 and 4, includes mobile support tools that support a workpiece 2 in key areas as the workpiece 2 rotates, replacing the functionality of the fully formed mandrel.

Figure 3 illustrates the principle features of a mandrel-free spinning apparatus 20, wherein a metal workpiece 2 is secured to a spinning lathe 4 and the workpiece 2 can be gradually deformed into a desired shape by a forming tool 6 which acts on an inner 28 or an outer 30 surface of the workpiece 2 as it rotates. A first support tool 32, shown proximal to the lathe 4, contacts an opposing surface of the workpiece 2 and can be moved according to a predetermined toolpath as the workpiece 2 rotates to resist deformation of the workpiece 2 and define a bending location along a perimeter of the artefact's base.

As the process proceeds, the workpiece 2 may be deformed such that it includes a longitudinal length and eventually an inner or outer surface of the workpiece 2 may come into contact with a second support tool 34 and a third support tool 36 of the mandrel-free spinning apparatus 20. The second and third support tools 34, 36 may be positioned towards a distal end of the workpiece 2 and can be moved as the workpiece 2 rotates such that they resist deformation of the workpiece 2 and allow formation of the artefact's longitudinal shape. In some applications, the second and third support tools 34, 36 may be moved to mimic the motion of the forming tool 6 and further guide the workpiece's deformation.

Figure 4 illustrates an end view of the mandrel-free spinning apparatus 20 shown in Figure 3. In this embodiment the first, second and third support tools 32, 34, 36 are shown acting against an inner surface 28 of the workpiece 2 whilst the forming tool 6 acts against an outer surface 30 of the workpiece 2. Applying force to opposing surfaces of the workpiece 2, as described, creates bending moments that guide the deformation into the desired shape of the article.

The success of any spinning process is influenced by the size and shape of the initial workpiece 2, or metal blank. An inappropriate workpiece 2 can increase the amount of material wastage and affect the quality of the finished article.

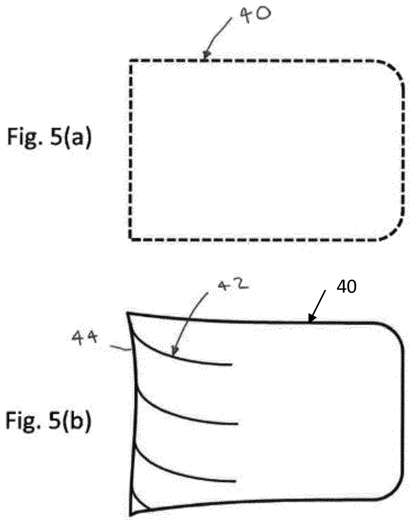

Figure 5(a) illustrates a profile of a desired article 40. Such an article 40 could be achieved by a traditional spin forming process, as described in Figure 1, or by a mandrel-free spin forming method, as described in Figure 3, by making use of an appropriately sized initial workpiece 2.

However, Figure 5(b) illustrates problems that arise when the initial workpiece 2 is inappropriately sized for the desired article 40. An oversized workpiece 2 will increase costs and lead to wrinkling 42 towards one end 44 of the article 40, as shown in Figure 5(b). As a result, one end 44 of the article 40 becomes splayed and warped by surface wrinkles 42 and the finished article may be unable to satisfy manufacturing tolerances.

Finite Element Analysis (FEA) has been used previously to inform workpiece designs and mitigate such issues. However, such analysis requires expertise in the field of FEA and can be time consuming, resource intensive and expensive. The analysis is also inflexible to changes and FEA models have to be redesigned as the shape of the desired article 40 changes. Thus, changes to article designs introduce additional analysis costs and tooling costs which increase the variation costs for spin forming processes.

By way of example: "Optimization of initial blank shape to minimize earing in deep drawing using finite element model", Naval Kishor et al, published in the 130th-131st Journal of Materials Processing Technology, discloses a method of designing a blank workpiece for a deep drawing process using a Finite element method; "A comparison of numerical iteration based algorithms in blank optimization", Fazli A et al, published in the 50th journal of Finite Elements in Analysis and Design, discloses an iterative method of designing a blank workpiece for a deep drawing process; and "Automatic design of sheet metal forming processes by 'un-forming'", Loukaides E et al, published in the 113th International Journal of Mechanical Sciences, discloses a method of predicting stresses in a metal forming process.

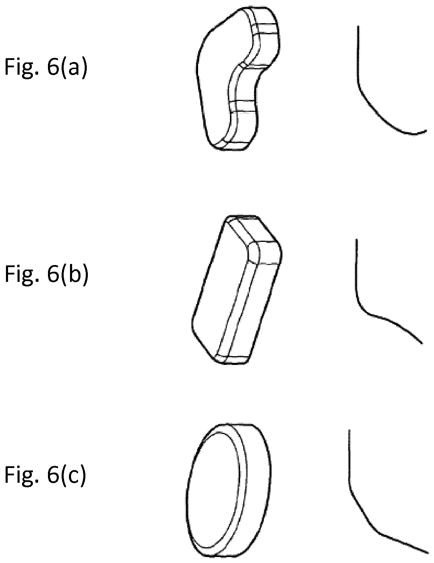

Further, in a mandrel-free spin forming process the workpiece 2 is only supported, at any given moment, in a few discrete locations by the first, second and third support tools 32, 34, 36. As a result, wrinkling effects can become more pronounced in a mandrel-free spin forming process compared to a traditional spin forming process. This problem can become further exacerbated when producing non-axisymmetric articles, such as those shown in Figure 6.

Inaccuracies, resulting from the FEA based design method, can produce inadequate workpiece designs and unusable products.

The present invention has been developed to mitigate at least some of the above-mentioned problems.

SUMMARY OF THE INVENTION

According to an aspect of the present invention there is provided a computer implemented method of generating a design of a blank workpiece, in a computer readable form, based on a target shape of an article to be formed from the blank workpiece in a spin forming process, wherein the target shape extends along an axis between a first end and a second end, the target shape comprising a base portion and a wall portion, wherein the base portion includes a central flat region at the first end and a curved region bordering the central flat region, and wherein the wall portion extends from the curved region of the base portion along the axis to the second end, the method including: determining a perimeter shape of the workpiece based on a planar representation of the base portion defined by a plurality of perimeter points; wherein each of the plurality of perimeter points has corresponding coordinates in a plane perpendicular to the axis between the first end and the second end; wherein determining the perimeter shape of the blank workpiece comprises, for each of the plurality of perimeter points: determining a vector, in the plane of the perimeter points, that is normal to the planar representation at said perimeter point; scaling the vector based on at least the curvature of the planar representation at said perimeter point and the length of the target shape; and adding the scaled vector to the coordinates of said perimeter point; and outputting the perimeter shape in the computer readable form.

By 'blank workpiece' it is intended to mean a shaped workpiece in an unformed state, wherein the spin forming process deforms the workpiece from the unformed state into the target shape.

Reference to the term 'target shape' is intended to mean the three dimensional shape of a desired article which comprises all of the article's visible surfaces.

By the term 'perimeter points' it is intended to mean points on the outer or inner surfaces of the target shape that lie in a single plane through the target shape. For example, the perimeter points may comprise points on the outer surfaces of the target shape that lie on a single plane which is transverse to the axis between the first end and the second end.

Advantageously, a basic three-dimensional form of the target shape can be inferred from the perimeter points of the base portion and the length of the target shape. The method can apply this understanding and use the curvature at each point to determine the unformed state of the workpiece in the form of a two-dimensional shape. For example, the two-dimensional shape may be determined by assuming that, during the spin forming process, the workpiece is only stretched in areas where the target shape has non-zero Gaussian curvature.

The axis between the first end and the second end may, for example, extend perpendicularly from the central flat region.

In this manner, the vector provides a direction for adjusting the coordinates of each perimeter point and scaling the vector adjusts the coordinates along the vector direction to positions that increase the suitability of the workpiece design for spin forming the article.

In an embodiment, the method may, for example, further include receiving a user input and scaling the vector additionally based on the user input. Advantageously, the user input allows recalibration of the perimeter shape. This may enable the method to manage more complex requirements and facilitate iterative improvements of the workpiece design.

Optionally, for each perimeter point, a corresponding point on the perimeter shape of the workpiece is given by:

$$B = S + L(1 - c.k)N$$

Where 'B' includes coordinates of the corresponding point on the perimeter shape of the workpiece, 'S' includes the coordinates of the perimeter point, 'k' includes the curvature of the planar representation at the perimeter point, 'L' includes the length of the target shape, 'N' includes the vector normal to the planar representation at the perimeter point and c is the user input.

In this manner, the method uses a mathematical function to apply the scaled vector to each perimeter point and determine the perimeter shape. Optionally, 'L' may include the length of the target shape from the first end to the second end which extends along a plane that bisects the perimeter point and the axis.

Optionally, the curved region comprises a curved wall of the target shape.

One or more of the perimeter points may, for example, have a non-zero Gaussian curvature. Thus, if the curvature at the perimeter point is non-zero then the method can assume that the target shape has non-zero Gaussian curvature at the perimeter point and hence that the material stretches at that perimeter point. Consequently the mathematical function will adjust the positions of the perimeter points accordingly.

Optionally, the perimeter shape of the workpiece represents a substantially net-shape for the article. By net-shape it is intended to mean that the workpiece design is suitably shaped such that a blank workpiece produced according to the workpiece design can be deformed in a spin forming process to substantially match the target shape.

The target shape may, for example, be non-axisymmetric or asymmetric. Designing a blank workpiece for a non-axisymmetric or an axisymmetric article is advantageous because such articles are more susceptible to wrinkling effects during a spin forming process.

In another aspect of the invention there is provided a method of producing a blank workpiece, for use in a spin forming process, including: generating a design of the blank workpiece in a computer readable form, in accordance with the method described in a previous aspect of the invention; outputting the design of the blank workpiece to a workpiece manufacturing machine; and controlling the workpiece manufacturing machine to produce a blank workpiece based on the design of the blank workpiece.

In an embodiment, the workpiece manufacturing machine may, for example, take the form of a blanking machine.

In a further aspect of the invention there is provided a method of producing an article in a spin forming process, including: producing a blank workpiece, in accordance with the method described in a previous aspect of the invention; mounting the workpiece on a spin forming machine; and operating the spin forming machine to deform the workpiece towards a shape that substantially matches the target shape of the article.

Reference to the 'shape that substantially matches the target shape' is intended to mean that the spin forming process deforms the workpiece into a shape that substantially reproduces the three dimensional shape of the desired article, allowing for manufacturing tolerances. In this manner, the dimensions, curvatures and volumes of the shape should match the dimensions, curvatures and volumes of the target shape, within allowable tolerances.

In an embodiment, the spin forming machine may, for example, take the form of a mandrel-free spinning apparatus. Advantageously, the mandrel-free spinning apparatus possess sufficient mobility to deform a workpiece into a variety of both axisymmetric and non-axisymmetric shapes and the absence of a fully formed mandrel enables the production of re-entrant shapes.

Within the scope of this application it is expressly intended that the various aspects, embodiments, examples and alternatives set out in the preceding paragraphs, in the claims and/or in the following description and drawings, and in particular the individual features thereof, may be taken independently or in any combination. That is, all embodiments and/or features of any embodiment can be combined in any way and/or combination, unless such features are incompatible. The applicant reserves the right to change any originally filed claim or file any new claim accordingly, including the right to amend any originally filed claim to depend from and/or incorporate any feature of any other claim although not originally claimed in that manner.

BRIEF DESCRIPTION OF THE DRAWINGS

One or more embodiments of the invention will now be described, by way of example only, with reference to the accompanying drawings, in which:

Figures 1 illustrates the operation of a traditional spin forming apparatus to form an article;

Figures 2 illustrates a range of articles, shown from a side view, that may be formed by the traditional spin forming apparatus, shown in Figure 1;

Figure 3 illustrates the operation of a mandrel-free spinning apparatus to form an article;

Figure 4 illustrates an end view of the mandrel free spinning apparatus, shown in Figure 3;

Figure 5(a) illustrates a side view of an example article. Figure 5(b) illustrates a side view of the example article shown in Figure 5(a), the example article having been formed from an incorrectly sized workpiece;

Figures 6(a) to 6(c) illustrate a range of non-axisymmetric articles that may be formed by the mandrel-free spinning apparatus, shown in Figure 5;

Figure 7 illustrates a workpiece which may be designed in accordance with the invention;

Figure 8 illustrates a method in accordance with the invention of determining a perimeter shape for the workpiece, shown in Figure 7, and producing an article from that workpiece in a spin forming process;

Figures 9(a) and 9(b) illustrate an initial operation of the spin forming process and a final operation of the spin forming process respectively;

Figures 10(a) and 10(b) illustrate an embodiment of an article formed by the spin forming process, the article taking the form of a square cup;

Figure 11 illustrates a radial section of the square cup shown in Figure 10;

Figure 12 illustrates curved segments of the square cup shown in Figure 10;

Figure 13 illustrates a method of determining perimeter edges of the workpiece based on the target shape;

Figures 14 and 15 graphically illustrate planar representations of a base portion of the square cup, shown in Figure 10;

Figure 16 illustrates a length of the square cup shown in Figure 10;

Figure 17 graphically illustrates determining a centre of curvature of a perimeter point of the planar representation, shown in Figures 14 and 15;

Figure 18 graphically illustrates determining normalised vectors of the perimeter points of the planar representation, shown in Figures 14 and 15;

Figures 19 and 20 graphically illustrate determining the coordinates, or relative positions, of points on a perimeter shape of the workpiece;

Figure 21 graphically illustrates determining the perimeter shape of the workpiece;

Figure 22 illustrates an alternative method of determining a length of an article;

Figure 23 illustrates another alternative method of determining a length of an article;

Figure 24 illustrates a system in accordance with the present invention for designing a workpiece, as shown in the previous figures, and manufacturing the workpiece for use in a spin forming process.

DETAILED DESCRIPTION

Embodiments of the invention relate to a method of generating a design of a blank workpiece, producing the workpiece from the design and producing an article, having a target shape, from the workpiece by means of a spin forming process. The method of design assumes that the spin forming process causes plastic elongation of the workpiece as convex regions of the target shape are formed. Advantageously, the method of design determines a perimeter shape of the workpiece which is based on the target shape and which makes allowance for the assumed plastic elongation.

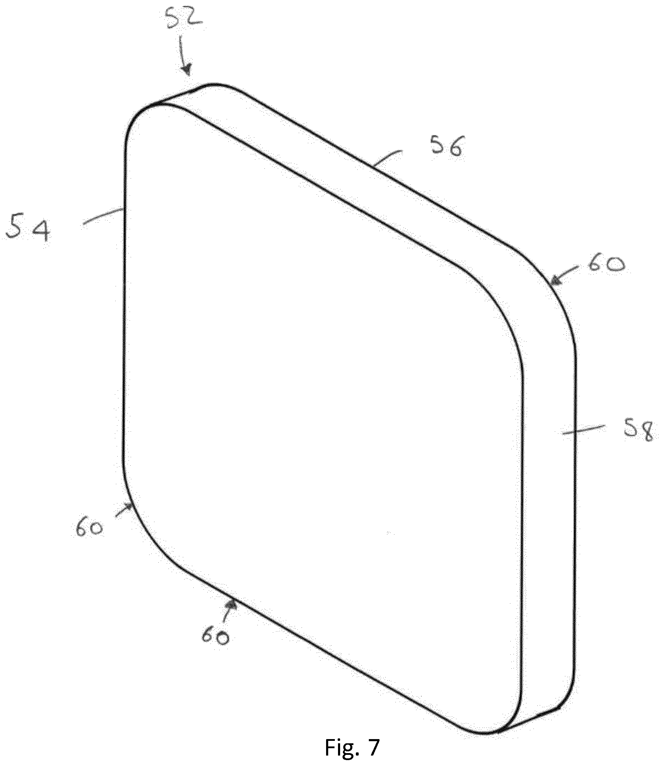

A workpiece 52 designed in accordance with this method is shown in Figure 7. The workpiece 52 may take the form of any relatively ductile material that is suitable for use in a spin forming process. More specifically, ductile metals such as aluminium and stainless steel may be used as well as certain composites thereof. The workpiece 52 has an inner surface 54 and an outer surface 56 and a thickness 58 disposed therebetween.

The workpiece 52 is cut or otherwise formed such that perimeter edges 60 of the inner and outer surfaces 54, 56 substantially match the predetermined perimeter shape. The thickness 58 of the workpiece 52 may, for example, correspond to a wall thickness of the desired article.

As a result, a spin forming process can deform the workpiece 52 to reproduce the target shape with minimal excess material or wrinkling. Consequently, the method reduces the reliance on finishing processes or trimming tasks to produce articles within tolerance of the target shape.

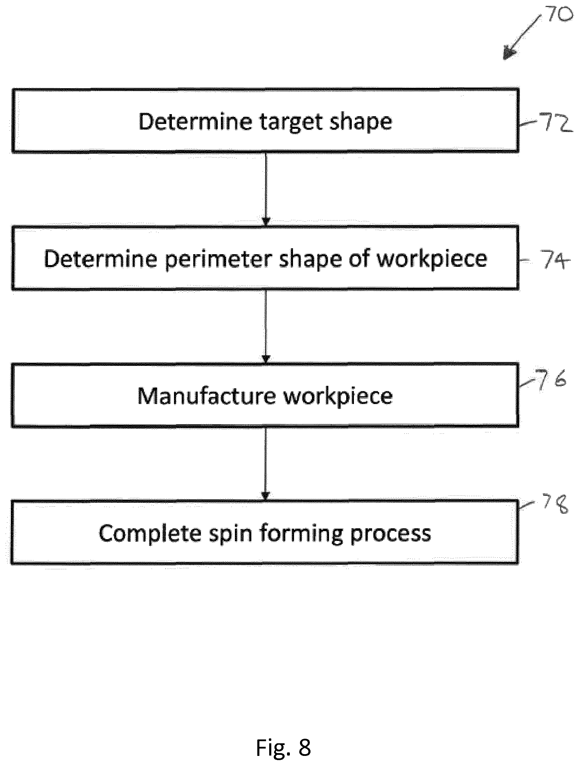

Figure 8 shows a method 70, in accordance with the invention, of producing an article by means of a spin forming process from an initial sheet of ductile material.

In the embodiment of the method described below, the spin forming machine takes the form of the mandrel-free spinning apparatus 20, substantially as described previously, and the perimeter shape of the workpiece 52 is based on a computerised representation of the article that provides the target shape. However, it should be appreciated that the spin forming process may be completed by any suitable spin forming machine.

In step 72, a computerised representation of the article, which provides the target shape, is determined.

In an embodiment of the invention, a computing device comprises the computerised representation of the article. The computerised representation may be produced on software of the computing device or generated elsewhere and received at the computing device. For example, the computerised representation may be received at the computing device from a memory storage device, a three-dimensional scanning device or a cloud storage system.

The computerised representation of the article may take various forms that provide sufficient detail to determine the perimeter shape of the workpiece 52. In an embodiment, the computerised representation of the article takes the form of a CAD model, which provides a three-dimensional representation of the article.

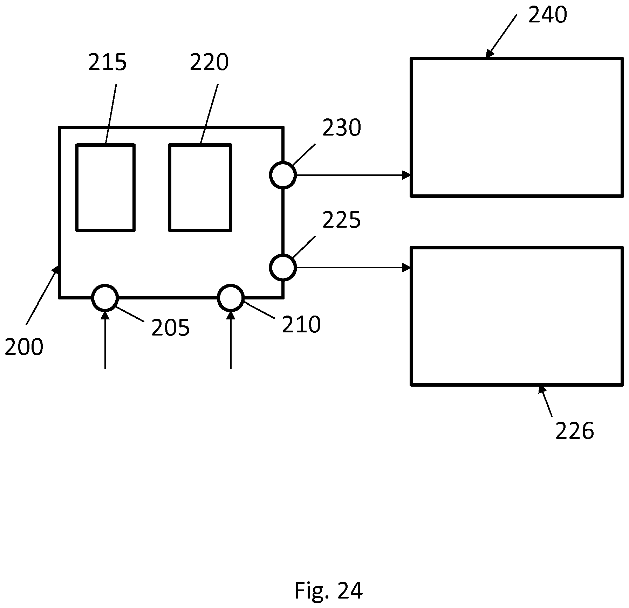

A suitable computing device 200 is shown in Figure 24 and includes a first input 205, such as a keyboard, for receiving user inputs; a second input 210, for receiving computerised representations of the article; a processor 215, for determining the perimeter shape of the workpiece; a memory storage 220, for storing a computerised representation of the article or a perimeter shape of the workpiece; a first output 225, for outputting information for display information, for example to a visual display unit 226; and a second output 230, for outputting the perimeter shape in a computer readable form.

In step 74, the computing device 200 determines the perimeter shape of the workpiece 52 based on the target shape.

In an embodiment of the invention, the computing device 200 is further configured to receive one or more user inputs in addition to the computerised representation of the article and to determine the perimeter shape based on the target shape and the user inputs.

The computing device 200 determines the perimeter shape of the workpiece 52 and converts the perimeter shape into a computer readable form or into a set of computer readable instructions that can be output to a workpiece manufacturing machine 240, as shown in Figure 24. The workpiece manufacturing machine 240 is configured to produce the workpiece 52 based on the output from the computing device 200. For example, the computing device 200 may determine the perimeter shape in a form suitable for a sheet metal manufacturing method that relies on CNC.

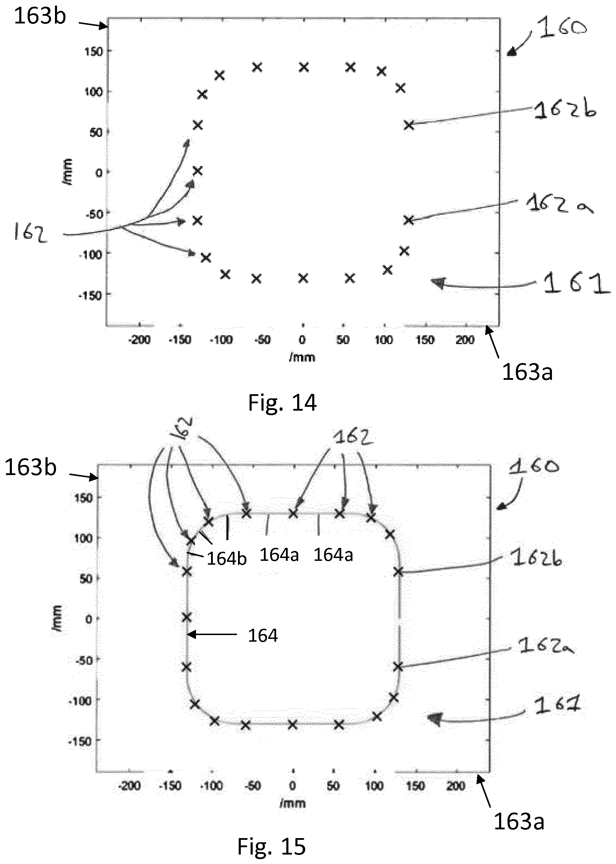

The method used to determine the perimeter shape of the workpiece 52 is described in more detail in relation to Figure 14.

In step 76, the computing device 200 outputs the perimeter shape of the workpiece 52 to the workpiece manufacturing machine 240 which manufactures the workpiece 52 from a chosen material.

In an embodiment, the workpiece manufacturing machine 240 takes the form of a blanking machine and cuts the workpiece 52 from sheet metal. The resulting workpiece 52 consists of a planar sheet of metal featuring perimeter edges 60 of the inner and outer surfaces 54, 56 that match the perimeter shape determined, in step 74, by the computing device 200.

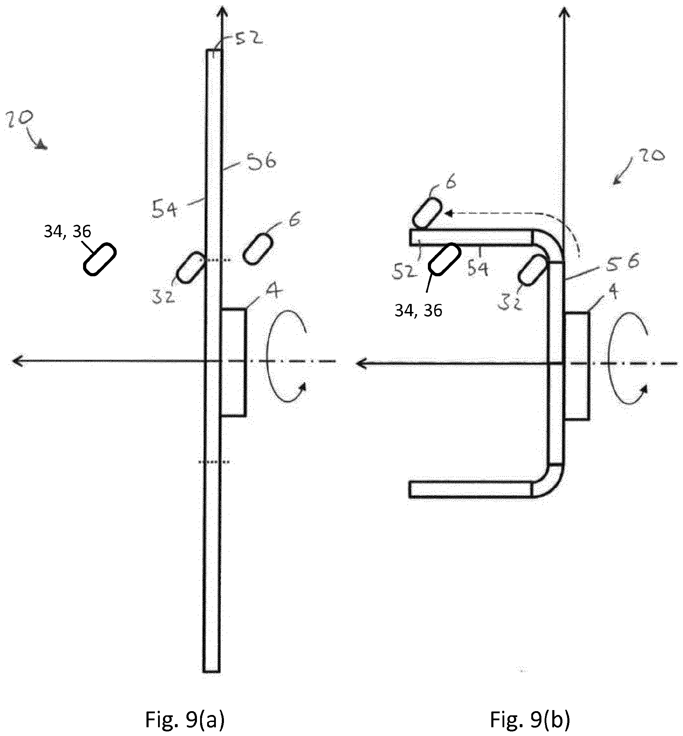

In step 78, the workpiece 52 is mounted on the lathe 4 of the spin forming machine and formed into the shape of the article by the forming tool 6, as illustrated by Figures 9(a) and 9(b).

The workpiece 52 is rotated on the lathe 4 and the forming tool 6 applies pressure to the outer surface 56 of the workpiece 52 to deform the workpiece 52 against the first, second and third support tools 32, 34, 36 to produce the desired article. The first support tool 32 acts to resist deformation of the workpiece 52 at the inner surface 54 of the workpiece 52 and defines a base portion of the article. Similarly, the second and third support tools 34, 36 mimic the movement of the forming tool 6 to support the inner surface 54 of the workpiece 52 and guide the deformation towards the target shape 80.

The forming tool 6 and the first, second and third support tools 32, 34, 36 may, for example, be controlled according to predetermined toolpaths based on the target shape such that the spin forming process can be automated and efficiently recalibrated as design changes alter the target shape. Figure 9(b) illustrates the final operations of the spin forming process.

At the conclusion, of step 78, the article is fully formed and the workpiece 52 substantially matches the target shape. Traditionally, various finishing process are required at the conclusion of a spin forming process which remove excess material, reform wrinkled surfaces and level the article to a uniform height. However, the invention provides a workpiece 52 that is designed to be substantially net shaped for the desired article. By substantially net shaped it is meant that the workpiece 52 is suitably shaped such that further finishing processes are not required at the conclusion of the spin forming process. Hence surface wrinkles should be minimised, the height of the article should be substantially uniform and there should be a negligible amount of excess material.

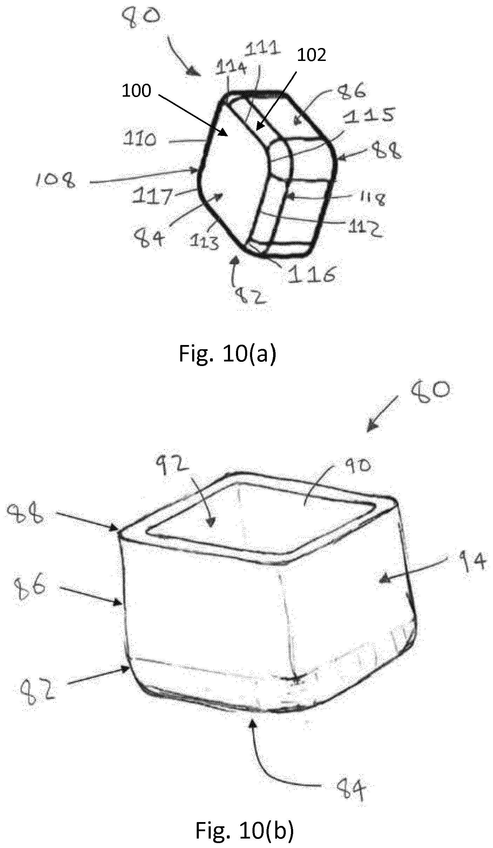

The method of determining the perimeter shape of the workpiece 52 based on the target shape, as mentioned in step 74, will now be described in more detail. The subsequent description will use an example article 80 in the form of a square cup shown in Figures 10(a) and 10(b).

The article 80 consists of a single workpiece 52 that has been deformed into a hollow shape. The article 80 comprises a base portion 82, at a first end 84; and a wall portion 86 that extends a short distance from the base portion 82 to a second end 88 of the article 80. In this manner, the article 80 extends a length along a longitudinal axis between the first end 84 and the second end 88.

The second end 88 features an opening 90 which makes an interior volume of the article 80 accessible and the hollow shape defines inner surfaces 92 and outer surfaces 94 of the article 80.

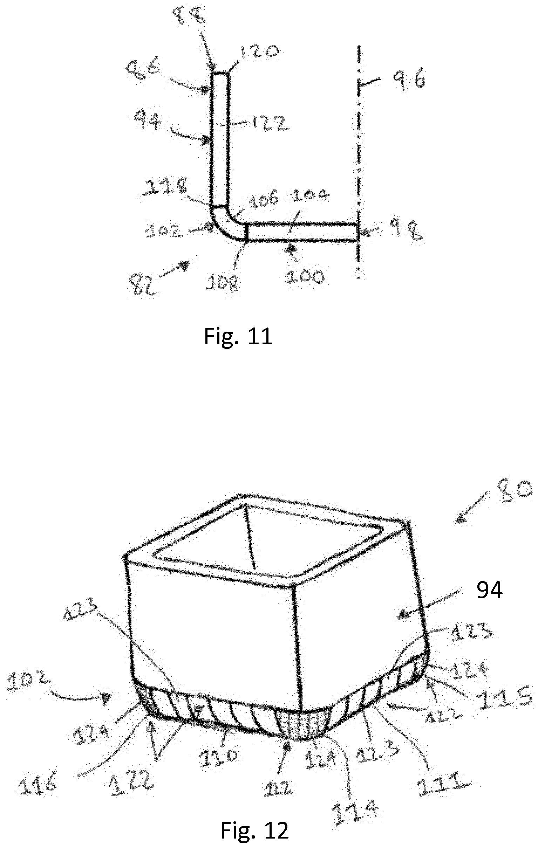

The subsequent description also considers Figure 11, which shows a radial section through the article 80. The radial section extends from a longitudinal axis 96 to the outer surfaces 94 of the article 80. The longitudinal axis 96 passes through a midpoint 98 of the article 80 and the midpoint 98 may, for example, be the midpoint 98 of the first end 84 of the article 80.

The base portion 82 includes a central flat region 100 and a curved region 102 that borders the central flat region 100. The central flat region 100 comprises a base wall 104 and the curved region 102 comprises curved walls 106 that extend around the base wall 104. Perimeter edges 108 of the central flat region 100 possess a square shape with rounded corners. The perimeter edges 108 are shown to include a first 110, a second 111, a third 112 and a fourth 113 straight edge and a first 114, a second 115, a third 116 and a fourth 117 rounded corner.

The curved region 102 extends from the perimeter edges 108 of the central flat region 100 to leading edges 118 of the wall portion 86. Trailing edges 120 of the wall portion 86 define the second end 88 of the article 80 and the wall portion 86 comprises one or more sidewalls 122.

Thus, the base portion 82 extends from the central flat region 100, at the first end 84 of the article 80, to the leading edges 118 of the wall portion 86 and the wall portion 86 extends from the leading edges 118 towards the trailing edges 120, at the second end 88 of the article 80. The base wall 104, curved walls 106 and sidewalls 122 have substantially constant wall thickness.

In the example provided, the curved walls 106 of the article 80 passes through an angle of approximately 90°, such that the sidewalls 122 extends from the curved region 102 approximately perpendicular to the base wall 104 of the base portion 82, as shown in Figure 11.

For the sake of clarity, the square cup 80 is one such example of an article that may be formed by the method of this invention. However, any article produced by this method will inevitably feature a base portion, which extends from a first end of the article to leading edges of a wall portion and includes a central flat region and a curved region that borders the central flat region, as well as a wall portion which extends from the base portion to trailing edges at a second end of the article.

It should also be understood that the perimeter edges of the central flat region will change depending on the geometry of the specific article considered and that the curved region will inevitably span around perimeter edges of the central flat region because the article is formed in a spin forming process. Therefore, at least one segment of the curved region will have non-zero principal curvature in a plane aligned with the longitudinal axis of the article and non-zero principal curvature in a plane perpendicular to the longitudinal axis.

Figure 12 illustrates a plurality of segments 122 that form the curved region 102 of the square cup 80. For each segment 122, the principal curvatures are constant across the segment's outer surfaces 94.

First segments 123 that extend from the first, second, third and fourth straight edges 110, 111, 112, 113 of the central flat region 100 have a non-zero principal curvature along the length of the article 80, but zero principal curvature in planes perpendicular to the length of the article 80.

Second segments 124 that extend from the first, second, third and fourth rounded corners 114, 115, 116, 117 of the central flat region 100 have non-zero principal curvature along the length of the article 80 and in planes perpendicular to the length of the article 80.

In other words, considering Figure 12 as a reference, the first segments 123 have a non-zero longitudinal curvature but zero transverse curvature. Whereas, the second segments 124 have non-zero longitudinal and transverse curvatures.

Accordingly, the second segments 124 have non-zero Gaussian curvature and the method 140 assumes that the spin forming process will cause plastic elongation of the workpiece 52 as the second segments 124 are formed.

Generally, the curved region 102 of the article 80 will feature one or more segments 124 with non-zero principal curvatures in two perpendicular directions, such that the one or more segments 124 have non-zero Gaussian curvature and the spin forming process will cause plastic elongation of the workpiece 52 as these one or more segments 124 are formed.

It should be appreciated that the features of the article 80 described above are equally present on the computerised representation of the article 80 and the target shape 80 comprises corresponding features.

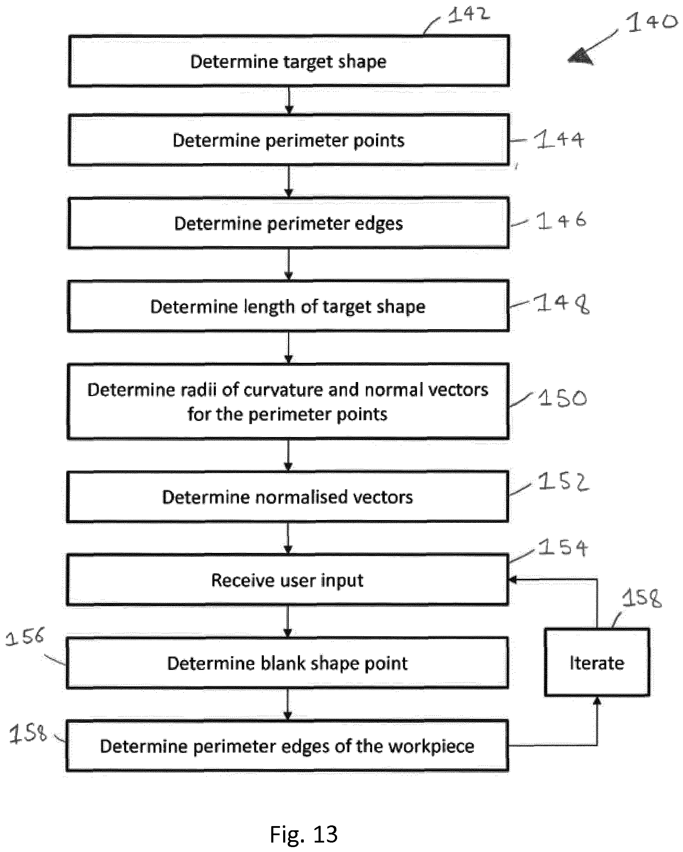

Figure 13 describes a method 140 of determining the perimeter edges 60 of the workpiece 52 based on the target shape 80.

Initially, in step 142, the computing device 200 comprises the computerised representation of the article 80, for example, in the form of a CAD model and the computerised representation provides the target shape 80 which the workpiece 52 is deformed towards during the spin forming process.

In step 144, the computing device 200 determines a planar representation 160 of the base portion 82 of the target shape 80, as illustrated in Figures 14 and 15. The planar representation 160 provides a principal shape 161 from which the computing device 200 is able to determine the perimeter edges 60 of the workpiece 52.

Figure 14 illustrates a planar representation 160 of the base portion 82 comprising a plurality of perimeter points 162 that correspond to the perimeter edges 108 of the central flat region 100 of the base portion 82. The computing device 200 is configured to determine coordinates for each of the plurality of perimeter points 162. The coordinates have a distance along a first axis 163a perpendicular to the longitudinal axis 96 and a distance along a second axis 163b perpendicular to both the longitudinal axis 96 and the first axis 163a.

In step 146, the computing device 200 determines perimeter edges 164 of the principal shape 161 based on the plurality of perimeter points 162, as illustrated by Figure 15.

The plurality of perimeter points 162 may, for example, have an associated order such that the computing device 200 is able to determine a plurality of straight or curved perimeter edges 164 that pass through successive perimeter points 162 to form a continuous perimeter between a first perimeter point 162a and a last perimeter point 162b.

For example, considering the perimeter points 162 in Figure 15, when successive perimeter points 162 have a matching distance along the first axis 163a or the second axis 163b then the computing device 200 determines a straight edge 164a through the two or more perimeter points 162. However, when successive perimeter points 162 do not have a matching distance along the first axis 163a or the second axis 163b then the computing device 200 can determine a curved edge 164b through the two or more perimeter points 162.

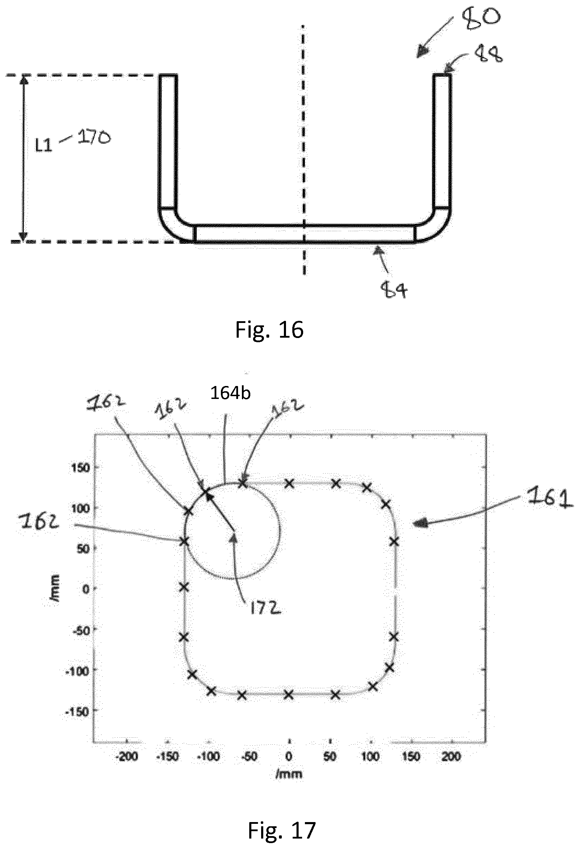

In step 148, the computing device 200 determines a length 170 of the target shape 80, between the first end 84 and the second end 88, as illustrated by Figure 16. The length 170 of the target shape 80 extends along the longitudinal axis 96 between the first end 84 and the second end 88.

For example, when the target shape 80 is a CAD model of the article 80, the length 170 may be determined by measuring the length along the longitudinal axis 96 between a point at the first end 84 of the target shape 80 and a point at the second end 88 of the target shape 80 to determine a height of the target shape 80. Equally, this may, for example, be achieved by comparing the longitudinal coordinates of points located at the first end 84 and at the second end 88 of the target shape 80.

In step 150, the computing device 200 determines a curvature and a normal vector for each perimeter point 162, as illustrated by Figure 17.

Figure 17 illustrates a centre of curvature 172 for the perimeter points 162 at a curved perimeter edge 164b of the principal shape 161. The computing device 200 determines the centre of curvature 172 by comparing the coordinates of successive perimeter points 162 on the curved perimeter edge 164b. The centre of curvature 172 is equidistant from each perimeter point 162 on the curved perimeter edge 164b.

The computing device 200 determines the normal vector of each perimeter point 162 on a curved perimeter edge 164b by determining a vector which acts from the centre of curvature 172 to the perimeter point 162. The computing device 200 determines a radius of curvature of the curved perimeter edge 164b from the magnitude of the normal vector and the computing device 200 determines the curvature of the curved perimeter edge 164b from the inverse of the radius of curvature.

The computing device 200 can determine a vector between successive perimeter points 162 on the straight perimeter edges 164a by comparing the coordinates of the perimeter points 162. Thus the computing device 200 can also determine a normal vector at each perimeter point 162 on the straight perimeter edges 164a and a curvature of zero.

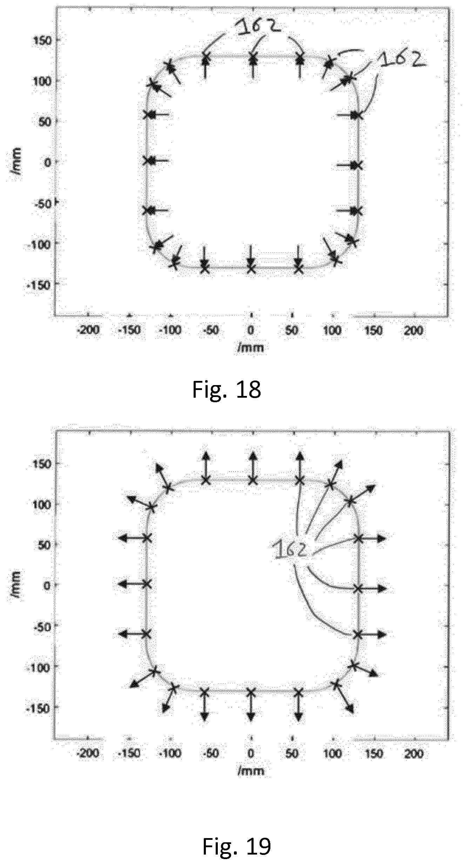

In step 152, the computing device 200 determines a normalised vector for each perimeter point 162 based on the normal vectors. Figure 18 illustrates normalised vectors relevant to each perimeter point 162.

At the end of step 152, the computing device 200 comprises the length 170 of the target shape 80, the normalised vector at each perimeter point 162 and the curvature at each perimeter point 162, which can be used to determine the coordinates of a plurality of blank shape points.

In step 154, the computing device 200 receives a user input. The user input provides a scalar term for adjusting each perimeter point 162 based on its curvature.

For the sake of clarity the user input is not an essential feature of the invention. However, the user input allows iterative refinement of the design of the workpiece 52 as the user input can scale the adjustments of the perimeter points 162 due to the curvature.

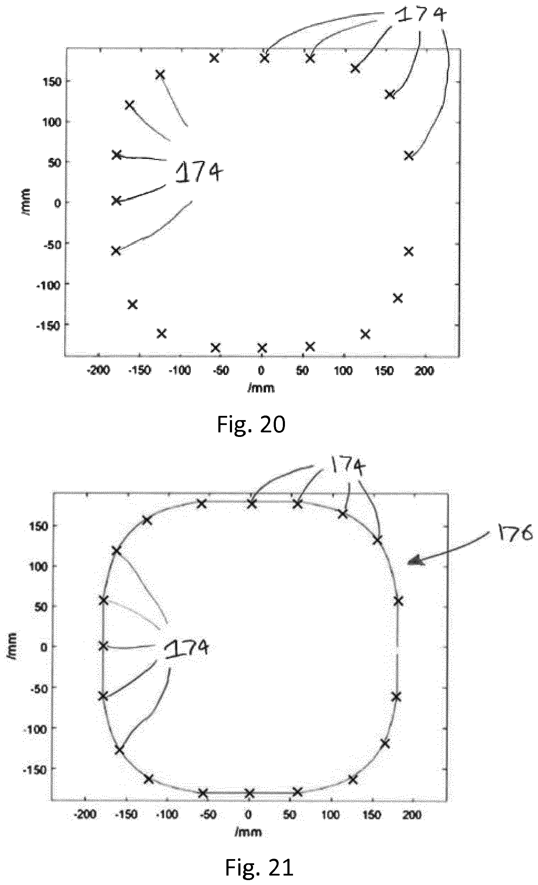

In step 156, the computing device 200 determines the coordinates, or relative positions, of the blank shape points 174 by adjusting the coordinates of one or more of the perimeter points 162, as shown in Figures 19 and 20.

For example, the coordinates of each perimeter point, '$s_i$', may be adjusted based on the length 170 of the target shape 80, between the first end 84 and the second end 88, '$L$', the normalised vector at the perimeter point, '$\vec{N_i}$', the curvature at the perimeter point, '$k_i$', and the user input, '$c$', in the following manner:

$$b_i = s_i + L.(1 - c.\kappa_i).\vec{N_i}$$

Where '$b_i$' is the blank shape point 174 based on the perimeter point '$s_i$' and '$L.(1 - c.\kappa_i).\vec{N_i}$' consitiutes an adjustment vector. Figure 19 illustrates the adjustment vectors applied to each perimeter point 162.

In this manner, for each perimeter point, the normal vector provides a direction for adjusting the coordinates of the perimeter point and the normal vector is scaled based on the curvature at the perimeter point, the length of the target shape and, optionally, the user input to determine the resultant adjustment vector which is added to the coordinates of the perimeter point. Thus, the distance to each blank shape point 174 is extended in the direction of the normalised vector to provide material for producing the longitudinal length of the target shape 80.

Advantageously, the adjustment vector is reduced when the blank shape point 174 is located on the outer surface 94 of a segment 122 of the target shape 80 which is convex and the adjustment vector is increased when the blank shape point 174 is located on the outer surface 94 of a segment 122 of the target shape 80 which is concave. The user input scales the influence of the curvature of the perimeter point 162 on the magnitude of the adjustment vector, such that the design can be iteratively improved.

In step 158, the computing device 200 determines the perimeter shape 176 of the workpiece 52 by connecting successive blank shape points 174 with straight edges or curved edges, as illustrated by Figure 21.

The straight edges and the curved edges are determined by comparing the coordinates of successive blank shape points 174, substantially as described when determining the perimeter edges 164 of the principal shape 161. The resulting perimeter shape 176 of the workpiece 52 is shown in Figure 21.

In step 158, the perimeter shape 176 of the workpiece 52 can be iterated as necessary by inputting different user inputs to the computing device 200. Different user inputs adjust the effect of the curvature of the target shape 80 on the perimeter shape 176 of the workpiece 52, which has a corresponding effect on the suitability of the workpiece 52 to forming the article 80 in the spin forming process.

It is noted that the steps of the method of designing the workpiece 140 and the method of producing a spin formed article 70 are merely provided as an example of the invention and the steps are not intended to limit the method of designing the workpiece 140 or the method of producing the article 70. Accordingly, it is understood that the processes involved in each method may be altered, reordered, added and removed as will be appreciated by the person skilled in the art.

In an embodiment, the planar representation 160 of the base portion 82, determined in step 144 of Figure 13, comprises a plurality of perimeter points 162 that correspond to the outer surfaces 94 of the target shape 80 through a plane perpendicular to the longitudinal axis 96. This plane may be considered for any longitudinal length of the target shape 80 between the first end 84 and the second end 88. In other words, the planar representation 160 may be considered for any longitudinal cross-section through the base portion or the wall portion.

For example, the planar representation 160 of the base portion 82 may comprise a plurality of perimeter points 162 that correspond to the perimeter edges 108 at the first end 84 of the article 80 or a plurality of perimeter points 162 that correspond to the leading edges 118 of the wall portion 86.

The method of designing the workpiece 140 then proceeds substantially as described previously and the computing device 200 is configured to determine coordinates for each of the plurality of perimeter points 162. The coordinates having a distance along a first axis 163a perpendicular to the longitudinal axis 96 and a distance along a second axis 163b perpendicular to both the longitudinal axis 96 and the first axis 163a.

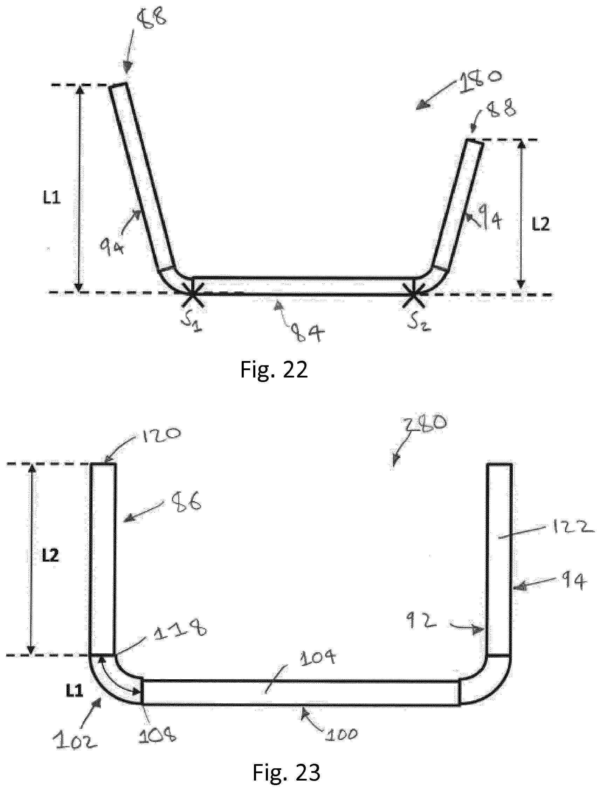

In an embodiment, the length of a target shape 180, between the first end 84 and the second end 88, varies around the perimeter of the target shape 180 as shown by the cross-section in Figure 22.

In this case, the computing device 200 determines a length of the target shape 180, between the first end 84 and the second end 88, for each perimeter point 162. Each length of the target shape 180 extends along a plane that bisects the perimeter point 162 and the longitudinal axis 96.

The coordinates of each perimeter point, '$s_i$, may be adjusted based on the length of the target shape 180 determined for each perimeter point, '$L_i$', the normalised vector at the perimeter point, '$\vec{N_i}$', the curvature at the perimeter shape point, '$k_i$', and the user input, '$c$', in the following manner:

$$b_i = s_i + L_i.(1 - c.\kappa_i).\overrightarrow{N_i}$$

Where '$b_i$' is the blank shape point based on the perimeter point '$s_i$' and '$L_i.(1 - c.\kappa_i).\overrightarrow{N_i}$' consititues the adjustment vector.

For example, at a first perimeter point, '$s_1$',

shown in Figure 22, the length of the target shape 180 is given by '$L_1$' and at a second perimeter point, '$s_2$', the length of the target shape 180 is given by '$L_2$'

Figure 23 also illustrates that the length of a target shape 280 may, for example, comprise a first length, '$L_1$', of the curved region 102 and a second length, '$L_2$', of the wall portion 86, as illustrated in Figure 23. The length of the target shape 280 extends parallel to the outer 94 or inner 92 surfaces of the target shape 280. The computing device 200 determines the first length, '$L_1$', in the form of an arc length of the curved region 102, which extends from the perimeter edges 108 of the central flat region 100 to the leading edges 118 of the wall portion 86. The computing device 200 also determines the second length, '$L_2$', from the leading edge 118 of the wall portion 86 to the trailing edge 120 of the wall portion 86 and the first and second lengths are summed together to determine the length of the target shape 280. The length of the target shape 280 may, for example, be determined in this manner when the sidewalls 122 of the article are inclined relative to the base wall 104 but are not perpendicular to the base wall 104.

Many modifications may be made to the above examples without departing from the scope of the present invention as defined in the accompanying claims.

**Claims**

1. A computer implemented method (140) of generating a design of a blank workpiece, in a computer readable form, based on a target shape of an article (80) to be formed from the blank workpiece in a spin forming process, wherein the target shape extends along an axis between a first end (84) and a second end (88), the target shape comprising a base portion (82) and a wall portion (86), wherein the base portion (82) includes a central flat region (100) at the first end (84) of the target shape and a curved region (102) bordering the central flat region (100), and wherein the wall portion (86) extends from the curved region (102) of the base portion (82) along the axis to the second end (88) of the target shape, **characterised in that** the method (140) includes:

    determining a perimeter shape (176) of the blank workpiece based on a planar representation (160) of the base portion (82) defined by a plurality of perimeter points (162);

    wherein each of the plurality of perimeter points (162) has corresponding coordinates in a plane perpendicular to the axis between the first end (84) and the second end (88); and
    wherein determining the perimeter shape (160) of the blank workpiece comprises, for each of the plurality of perimeter points (162):

determining a vector, in the plane of the perimeter points (162), that is normal to the planar representation (160) at said perimeter point (162);

scaling the vector based on at least the curvature of the planar representation (160) at said perimeter point (162) and the length of the target shape between the first end (84) and the second end (88); and

adding the scaled vector to the coordinates of said perimeter point (162); and

outputting the perimeter shape (160) in the computer readable form.

2. The method (140) as claimed in Claim 1, further including receiving a user input and scaling the vector additionally based on the user input.

3. The method (140) as claimed in Claim 2, wherein, for each perimeter point (162), a corresponding point (174) on the perimeter shape (176) of the workpiece is given by:

$$B = S + L(1 - c.k)N$$

Where 'B' includes coordinates of the corresponding point (174) on the perimeter shape (176) of the workpiece, 'S' includes the coordinates of the perimeter point (162), 'k' includes the curvature of the planar representation (160) at the perimeter point (162), 'L' includes the length of the target shape, 'N' includes the vector normal to the planar representation (160) at the perimeter point (162) and c is the user input.

4. The method (140) as claimed in any preceding claim, wherein the curved region comprises a curved wall (106) of the target shape.

5. The method (140) as claimed in any preceding claim, wherein one or more of the perimeter points (162) have a non-zero Gaussian curvature.

6. The method (140) as claimed in any preceding claim, wherein the perimeter shape (176) of the workpiece represents a substantially net-shape for the article (80).

7. The method (140) as claimed in any preceding claim, wherein the target shape is non-axisymmetric or asymmetric.

8. A method (70) of producing a blank workpiece, for use in a spin forming process, including:

generating a design of the blank workpiece in a computer readable form in accordance with the method as claimed in any one of claims 1 to 7;

outputting the design of the blank workpiece to a workpiece manufacturing machine (240); and

controlling the workpiece manufacturing machine (240) to produce a blank workpiece based on the design of the blank workpiece.

9. The method (70) as claimed in Claim 8, wherein the workpiece manufacturing machine (240) takes the form of a blanking machine.

10. A method (70) of producing an article (80) in a spin forming process, including:

producing a blank workpiece in accordance with the method as claimed in Claim 8 or Claim 9;

mounting the workpiece on a spin forming machine (20); and

operating the spin forming machine (20) to deform the workpiece towards a shape that substantially matches the target shape of the article.

11. The method (70) as claimed in claim 10, wherein the spin forming machine (20) takes the form of a mandrel-free spinning apparatus (20).

**Patentansprüche**

1. Computerimplementiertes Verfahren (140) zum Erzeugen eines Entwurfs eines Rohlingwerkstücks in einer computerlesbaren Form, basierend auf einer Zielgestalt eines Artikels (80), der aus dem Rohlingwerkstück in einem Drückvorgang geformt werden soll, wobei sich die Zielgestalt entlang einer Achse zwischen einem ersten Ende (84) und einem zweiten Ende (88) erstreckt, wobei die Zielgestalt einen Basisabschnitt (82) und einen Wandabschnitt (86) umfasst, wobei der Basisabschnitt (82) einen zentralen flachen Bereich (100) an dem ersten Ende (84) der Zielgestalt und einen gekrümmten Bereich (102), der an den zentralen flachen Bereich (100) angrenzt, umfasst, und wobei sich der Wandabschnitt (86) von dem gekrümmten Bereich (102) des Basisabschnitts (82) entlang der Achse zu dem zweiten Ende (88) der Zielgestalt erstreckt, **dadurch gekennzeichnet, dass** das Verfahren (140) Folgendes beinhaltet:

Bestimmen einer Umfangsgestalt (176) des Rohlingwerkstücks basierend auf einer planaren Darstellung (160) des Basisabschnitts (82), der durch mehrere Umfangspunkte (162) definiert ist;

wobei jeder der mehreren Umfangspunkte (162) entsprechende Koordinaten in einer Ebene rechtwinklig zu der Achse zwischen dem ersten Ende (84) und dem zweiten Ende (88) aufweist; und

wobei das Bestimmen der Umfangsgestalt (160) des Rohlingwerkstücks für jeden der mehreren Umfangspunkte (162) Folgendes umfasst:

Bestimmen eines Vektors in der Ebene der Umfangspunkte (162), der senkrecht zu der planaren Darstellung (160) an dem Umfangspunkt (162) ist;
Skalieren des Vektors basierend auf mindestens der Krümmung der planaren Darstellung (160) an dem Umfangspunkt (162) und der Länge der Zielgestalt zwischen dem ersten Ende (84) und dem zweiten Ende (88); und
Addieren des skalierten Vektors zu den Koordinaten des Umfangspunktes (162); und
Ausgeben der Umfangsgestalt (160) in der computerlesbaren Form.

2. Verfahren (140) nach Anspruch 1, das ferner ein Empfangen einer Benutzereingabe und das zusätzliche Skalieren des Vektors basierend auf der Benutzereingabe beinhaltet.

3. Verfahren (140) nach Anspruch 2, wobei für jeden Umfangspunkt (162) ein entsprechender Punkt (174) auf der Umfangsgestalt (176) des Werkstücks gegeben ist durch:

$$B = S + L(1 - c.k)N$$

wobei 'B' die Koordinaten des entsprechenden Punktes (174) auf der Umfangsgestalt (176) des Werkstücks beinhaltet, 'S' die Koordinaten des Umfangspunktes (162) beinhaltet, 'k' die Krümmung der planaren Darstellung (160) an dem Umfangspunkt (162) beinhaltet, 'L' die Länge der Zielgestalt beinhaltet, 'N' die Vektornormale zu der planaren Darstellung (160) an dem Umfangspunkt (162) beinhaltet und c die Benutzereingabe ist.

4. Verfahren (140) nach einem der vorhergehenden Ansprüche, wobei der gekrümmte Bereich eine gekrümmte Wand (106) der Zielgestalt umfasst.

5. Verfahren (140) nach einem der vorhergehenden Ansprüche, wobei einer oder mehrere der Umfangspunkte (162) eine von Null verschiedene Gaußsche Krümmung aufweisen.

6. Verfahren (140) nach einem der vorhergehenden Ansprüche, wobei die Umfangsgestalt (176) des Werkstücks im Wesentlichen eine Netzgestalt für den Artikel (80) darstellt.

7. Verfahren (140) nach einem der vorhergehenden Ansprüche, wobei die Zielgestalt nicht achsensymmetrisch oder asymmetrisch ist.

8. Verfahren (70) zum Herstellen eines Rohlingwerkstücks zur Verwendung in einem Drückvorgang, das Folgendes beinhaltet:

Erzeugen eines Entwurfs des Rohlingwerkstücks in einer computerlesbaren Form gemäß dem Verfahren nach einem der Ansprüche 1 bis 7;
Ausgeben des Entwurfs des Rohlingwerkstücks an eine Werkstückfertigungsmaschine (240); und
Steuern der Werkstückfertigungsmaschine (240), um ein Rohlingwerkstücks basierend auf dem Entwurf des Rohlingwerkstücks herzustellen.

9. Verfahren (70) nach Anspruch 8, wobei die Werkstückfertigungsmaschine (240) die Form einer Stanzmaschine hat.

10. Verfahren (70) zum Herstellen eines Artikels (80) in einem Drückvorgang, das Folgendes beinhaltet:

Herstellen eines Rohlingwerkstücks gemäß dem Verfahren nach Anspruch 8 oder 9;
Aufspannen des Werkstücks auf eine Drückmaschine (20); und
Betreiben der Drückmaschine (20), um das Werkstück in eine Gestalt zu verformen, die im Wesentlichen der Zielgestalt des Artikels entspricht.

11. Verfahren (70) nach Anspruch 10, wobei die Drückmaschine (20) die Form einer dornlosen Drückvorrichtung (20) hat.

**Revendications**

1. Procédé (140) mis en œuvre par ordinateur pour générer une conception d'une ébauche de pièce, sous une forme lisible par ordinateur, sur la base d'une forme cible d'un article (80) à former à partir de l'ébauche de pièce dans un processus de formation par rotation, la forme cible s'étendant le long d'un axe entre une première extrémité (84) et une seconde extrémité (88), la forme cible comprenant une partie de base (82) et une partie de paroi (86), la partie de base (82) comportant une région plate centrale (100) au niveau de la première extrémité (84) de la forme cible et une région incurvée (102) bordant la région plate centrale (100), et la partie de paroi (86) s'étendant à partir de la région incurvée (102) de la partie de base (82) le long de l'axe jusqu'à la seconde extrémité (88) de la forme cible, **caractérisé en ce que** le procédé (140) comporte :

la détermination d'une forme périphérique (176) de l'ébauche de pièce sur la base d'une représentation plane (160) de la partie de base (82) définie par une pluralité de points périphériques (162) ;

chacun de la pluralité de points périphériques (162) ayant des coordonnées correspondantes dans un plan perpendiculaire à l'axe entre la première extrémité (84) et la seconde extrémité (88) ; et

la détermination de la forme périphérique (160) de l'ébauche de pièce comprenant, pour chacun de la pluralité de points périphériques (162) :

la détermination d'un vecteur, dans le plan des points périphériques (162), qui est perpendiculaire à la représentation plane (160) au niveau dudit point périphérique (162) ;

la mise à l'échelle du vecteur sur la base d'au moins la courbure de la représentation plane (160) au niveau dudit point périphérique (162) et de la longueur de la forme cible entre la première extrémité (84) et la seconde extrémité (88) ; et

l'ajout du vecteur mis à l'échelle aux coordonnées dudit point périphérique (162) ; et

la délivrance de la forme périphérique (160) sous la forme lisible par ordinateur.

2.  Procédé (140) selon la revendication 1, comportant en outre la réception d'une entrée utilisateur et la mise à l'échelle du vecteur sur la base également de l'entrée utilisateur.

3.  Procédé (140) selon la revendication 2, dans lequel, pour chaque point périphérique (162), un point correspondant (174) sur la forme périphérique (176) de la pièce est donné par :

$$ B = S + L(1 - c.k)N $$

où « $B$ » comporte les coordonnées du point correspondant (174) sur la forme périphérique (176) de la pièce, « $S$ » comporte les coordonnées du point périphérique (162), « $k$ » comporte la courbure de la représentation plane (160) au niveau du point périphérique (162), « $L$ » comporte la longueur de la forme cible, « $N$ » comporte le vecteur perpendiculaire à la représentation plane (160) au niveau du point périphérique (162) et c est l'entrée utilisateur.

4.  Procédé (140) selon l'une quelconque des revendications précédentes, dans lequel la région incurvée comprend une paroi incurvée (106) de la forme cible.

5.  Procédé (140) selon l'une quelconque des revendications précédentes, dans lequel un ou plusieurs des points périphériques (162) ont une courbure gaussienne non nulle.

6.  Procédé (140) selon l'une quelconque des revendications précédentes, dans lequel la forme périphérique (176) de la pièce représente une forme sensiblement en filet pour l'article (80).

7.  Procédé (140) selon l'une quelconque des revendications précédentes, dans lequel la forme cible est non axisymétrique ou asymétrique.

8.  Procédé (70) de production d'une ébauche de pièce, à utiliser dans un processus de formation par rotation, comportant :

la génération d'une conception de l'ébauche de pièce sous une forme lisible par ordinateur conformément au procédé selon l'une quelconque des revendications 1 à 7 ;

la délivrance de la conception de l'ébauche de pièce à une machine de fabrication de pièces (240) ; et

la commande de la machine de fabrication de pièces (240) pour produire une ébauche de pièce sur la base de la conception de l'ébauche de pièce.

9.  Procédé (70) selon la revendication 8, dans lequel la machine de fabrication de pièces (240) prend la forme d'une machine à découper.

10. Procédé (70) de production d'un article (80) dans un processus de formation par rotation, comportant :

la production d'une ébauche de pièce conformément au procédé selon la revendication 8 ou la revendication 9 ;

le montage de la pièce sur une machine de formation par rotation (20) ; et

le fonctionnement de la machine de formation par rotation (20) pour déformer la pièce en une forme qui correspond sensiblement à la forme cible de l'article.

11. Procédé (70) selon la revendication 10, dans lequel la machine de formation par rotation (20) prend la forme d'un appareil de repoussage sans mandrin (20).

FIG. 1

Fig. 2

Fig. 3

Fig. 4

Fig. 5(a)

Fig. 5(b)

Fig. 6(a)

Fig. 6(b)

Fig. 6(c)

Fig. 7

70

| Determine target shape | 72 |

↓

| Determine perimeter shape of workpiece | 74 |

↓

| Manufacture workpiece | 76 |

↓

| Complete spin forming process | 78 |

Fig. 8

Fig. 9(a)　　　　　　　　　　Fig. 9(b)

Fig. 10(a)

Fig. 10(b)

Fig. 11

Fig. 12

```
                                          142                    140

    ┌─────────────────────────────────────────┐
    │         Determine target shape           │
    └─────────────────────────────────────────┘
                      │
                      ▼
    ┌─────────────────────────────────────────┐
    │        Determine perimeter points        │──── 144
    └─────────────────────────────────────────┘
                      │
                      ▼
    ┌─────────────────────────────────────────┐
    │        Determine perimeter edges         │──── 146
    └─────────────────────────────────────────┘
                      │
                      ▼
    ┌─────────────────────────────────────────┐
    │      Determine length of target shape    │──── 148
    └─────────────────────────────────────────┘
                      │
                      ▼
    ┌─────────────────────────────────────────┐
    │  Determine radii of curvature and normal │
    │      vectors for the perimeter points    │──── 150
    └─────────────────────────────────────────┘
                      │
                      ▼
    ┌─────────────────────────────────────────┐
    │        Determine normalised vectors      │──── 152
    └─────────────────────────────────────────┘
                      │
                      ▼
    ┌─────────────────────────────────────────┐            154
    │            Receive user input            │◄───┐
    └─────────────────────────────────────────┘    │        158
                      │                         ┌────────┐
                      ▼                         │ Iterate │
    ┌─────────────────────────────────────────┐ └────────┘
156 │        Determine blank shape point       │     ▲
    └─────────────────────────────────────────┘     │
                      │                              │
                      ▼                              │
158 │ Determine perimeter edges of the workpiece│────┘
    └─────────────────────────────────────────┘
```

Fig. 13

22

Fig. 14

Fig. 15

Fig. 16

Fig. 17

Fig. 18

Fig. 19

Fig. 20

Fig. 21

Fig. 22

Fig. 23

Fig. 24

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2012042221 A1

**Non-patent literature cited in the description**

- **NAVAL KISHOR et al.** Optimization of initial blank shape to minimize earing in deep drawing using finite element model. *the 130th-131st Journal of Materials Processing Technology*

- **FAZLI A et al.** A comparison of numerical iteration based algorithms in blank optimization. *the 50th journal of Finite Elements in Analysis and Design*
- **LOUKAIDES E et al.** Automatic design of sheet metal forming processes by 'un-forming. *the 113th International Journal of Mechanical Sciences*